# EUROPÄISCHE PATENTSCHRIFT

(11) **EP 2 544 215 B1**
(45) Veröffentlichungstag und Bekanntmachung des Hinweises auf die Patenterteilung: **20.05.2015**
(21) Anmeldenummer: 12173737.3
(22) Anmeldetag: 27.06.2012
(51) Int. Cl.: H01J 37/32, C01B 33/035, C23C 16/44, C23C 16/46

(54) **Schutzvorrichtung für Elektrodenhalterungen in CVD Reaktoren**
Protective device for electrode holders in CVD reactors
Dispositif de protection de supports d'électrodes dans des réacteurs CVD

(30) Priorität: 06.07.2011 DE 102011078727
(43) Veröffentlichungstag der Anmeldung: 09.01.2013
(73) Patentinhaber: Wacker Chemie AG, 81737 München (DE)
(72) Erfinder: Müller, Barbara, 84567 Erlbach (DE); Kraus, Heinz, 84367 Zeilarn (DE); Monz, Elmar, 84533 Marktl (DE); Sofin, Mikhail, 84489 Burghausen (DE)
(74) Vertreter: Killinger, Andreas

(56) Entgegenhaltungen:
- EP-A2- 2 161 241
- WO-A1-2011/092276
- DE-A1- 2 432 383
- US-A1- 2010 147 219

## Beschreibung

Die Erfindung betrifft eine Vorrichtung zum Schutz von Elektrodenhalterungen in CVD Reaktoren.

Hochreines polykristallines Silicium (Polysilicium) wird in der Regel mittels des Siemensprozesses hergestellt. Dabei wird ein Reaktionsgas enthaltend eine oder mehrere Silicium enthaltende Komponenten und gegebenenfalls Wasserstoff in einen Reaktor, beinhaltend durch direkten Stromdurchgang erhitze Trägerkörper, eingeleitet, an denen sich Silicium in fester Form abscheidet.

Als Silicium enthaltende Verbindungen werden bevorzugt Silan (SiH₄), Monochlorsilan (SiH₃Cl), Dichlorsilan (SiH₂Cl₂), Trichlorsilan (SiHCl₃), Tetrachlorsilan (SiCl₄) bzw. deren Mischungen eingesetzt.

Jeder Trägerkörper besteht meistens aus zwei dünnen Filamentstäben und einer Brücke, die in der Regel benachbarte Stäbe an ihren freien Enden verbindet. Am häufigsten werden die Filamentstäbe aus ein- oder polykristallinem Silicium gefertigt, seltener kommen Metalle bzw. Legierungen oder Kohlenstoff zum Einsatz. Die Filamentstäbe stecken senkrecht in am Reaktorboden befindlichen Elektroden über die der Anschluss an die Elektrodenhalterung und Stromversorgung erfolgt. An den erhitzten Filamentstäben und der waagrechten Brücke scheidet sich hochreines Polysilicium ab, wodurch deren Durchmesser mit der Zeit anwächst. Nachdem der gewünschte Durchmesser erreicht ist, wird der Prozess beendet.

Die Siliciumstäbe werden im CVD Reaktor von speziellen Elektroden gehalten, die in der Regel aus Graphit bestehen. Jeweils zwei Dünnstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt. Dabei wächst der Durchmesser der Dünnstäbe. Gleichzeitig wächst die Elektrode, beginnend an ihrer Spitze, in den Stabfuß der Siliciumstäbe ein. Nach dem Erreichen eines gewünschten Solldurchmessers der Siliciumstäbe wird der Abscheideprozess beendet, die Siliciumstäbe abgekühlt und ausgebaut.

Eine besondere Bedeutung kommt hier dem Schutz der durch die Bodenplatte geführten Elektrodenhalterung und die umgebende Dichtung zu. Da der Trend zu immer längeren und dickeren Stäben in kürzeren Abscheidungszyklen geht, ist gerade die Anordnung und Form der Elektrodendichtungsschutzkörper sowie das Material der zu schützenden Dichtung von Bedeutung. Denn durch eine optimierte Anordnung können die mögliche Ausbeute und oder Qualität beeinflussende Störungen beim Prozess der Abscheidung von Polysilicium vermieden werden. Zu den möglichen Störungen beim Abscheideprozess, die die Ausbeute oder Qualität beeinflussen, gehören zum Beispiel auch elektrische Ausfälle durch Erdschlüsse während der Abscheidung. Diese Störung reduziert die Ausbringung, weil der Prozess vorzeitig abgebrochen wird.

Auch je nach der späteren Verwendung der so erzeugten Siliciumstäbe werden sehr unterschiedliche Anforderungen an die Siliciumstäbe und den Abscheideprozess, und somit an die Elektrodenhalterung und deren Schutz gestellt. Wird beispielsweise das polykristalline Silicium später in Siliciumbruchstücken für Solar- und Elektronik Anwendungen verwendet, dürfen die Siliciumstäbe während oder nach dem Abscheideprozess im Abscheidereaktor nicht umfallen oder durch austretende Fremdstoffe aus z.B. produktberührenden Dichtungsmaterialien verunreinigt werden. Lange und dicke polykristalline Siliciumstäbe erhöhen die Wirtschaftlichkeit des Abscheideprozesses, aber auch das Risiko des Umfallens im Reaktor.

In dem WO-Patent 2010/083899 A1 ist eine Elektrodenschutzvorrichtung nach dem Stand der Technik offenbart. Dabei werden Dünnstäbe in einem Graphitadapter, der in einen Graphitspannring eingreift, der selbst über einen Quarzring mit der Bodenplatte des CVD Reaktors zur Herstellung von polykristallinem Silicium nach dem Monosilan-Prozess zusammenwirkt beschrieben.

Im Stand der Technik wurde versucht, die Problematik der elektrischen Ausfälle durch Dichtung und Isolierung der durch die Bodenplatte geführten Elektrode zu lösen.

Aus WO 2010/083899 A1 ist bekannt, die Dichtungen der Elektroden mittels Schutzringen aus Quarz gegen thermische Belastung abzuschirmen.

In DE 23 28 303 A1 ist eine Vorrichtung beschrieben zum Herstellen von Stäben und Rohren aus Silicium durch Abscheiden des betreffenden Halbleitermaterials aus der Gasphase an der Mantelfläche eines erhitzten langgestreckten Trägers, insbesondere aus Silicium oder Graphit, bestehend aus einem eine Bodenplatte aus Metall aufweisenden Reaktionsgefäß mit mindestens einer zur Halterung eines Endes des langgestreckten Trägers und zur Beheizung des Trägers dienenden Elektrode versehen ist, die elektrisch isoliert und dicht durch die Bodenplatte hindurchgeführt ist, dadurch gekennzeichnet, dass ein erster aus Metall bestehender Elektrodenteil unter Zwischenfügung einer abdichtenden Schicht aus inertem, isolierenden Material, insbesondere Tetrafluorpolyäthylen, in der Bodenplatte befestigt ist und einen in den Reaktionsraum ragenden Vorsprung aufweist, auf den ein weiterer aus Metall oder Kohlenstoff bestehender Elektrodenteil auswechselbar aufsitzt, der an seiner freien Oberfläche die zur Aufnahme und Halterung des Trägers bestimmte Passfläche besitzt.

Ein erster aus Metall bestehender Teil der Elektrodenhalterung ist also unter Zwischenführung einer abdichtenden Schicht aus inertem isolierenden Material in der Bodenplatte befestigt.

JP 2009-221058 A2 offenbart eine Abdichtung und Isolierung durch den Einsatz einer speziellen Zirkonium-Keramik, von flexiblem Graphit, und beschichteten O-Ringen als Dichtung. Solche Materialien weisen eine Hochtemperaturbeständigkeit auf und ermöglichen eine Versiegelung des Spalts zwischen Elektroden und Bodenplatte.

WO 2010/068849 A1 beschreibt eine verbesserte thermische Isolierung im Bereich der Durchführung der Elektroden durch die Bodenplatte durch Einsatz eines Metallkörpers, der mit einer isolierenden Oberflächenbeschichtung versehen ist.

US 2010/147219 A1 offenbart eine Elektrode zur Aufnahme eines Filamentstabs, das in einer Aussparung einer Bodenplatte angebracht ist, wobei zwischen Bodenplatte und Elektrode ein Dichtungsmaterial angebracht ist, das durch einen um die Elektrode kreisförmig angebrachten Elektrodenring geschützt wird und aus einem isolierenden Material wie Keramik oder Quarz besteht.

WO 2011/092276 A1 offenbart eine Elektrode für einen Reaktor zur Herstellung von polykristallinem Silizium, wobei mehrere Elektroden in einer Bodenplatte des Reaktors befestigt sind und Filamentstäbe tragen, wobei die Elektrode mit mehreren elastischen Elementen in Richtung einer Oberseite der Bodenplatte hin mechanisch vorgespannt ist und wobei zwischen Bodenplatte und Elektrode ein radial umlaufendes Dichtelement eingesetzt ist. Das Dichtelemnt kann von einem Keramikring abgeschirmt sein.

DE 24 32 383 A1 offenbart einen Reaktor mit Elektroden, die zur Halterung und elektrischen Beheizung von Filamentstäben dienen, und gasdicht durch eine metallische Bodenplatte hindurchgeführt sind, wobei die Elektroden sowie die Bodenplatte an der an den Reaktionsraum grenzenden Oberfläche aus Silber bestehen, wobei die einzelnen Elektroden aus mindestens je einem Körper aus Feinsilber und mindestens je einem Körper aus einem minderwertigeren, aber elektrisch gut leitenden Metall wie z.B. Kupfer derart zusammengesetzt sind, dass nur der aus Feinsilber bestehende Elektrodenteil an den Reaktionsraum angrenzt.

EP 2 161 241 A2 offenbart einen Reaktor mit einer Elektrode, die den Siliziumimpfstab hält und aus Graphit besteht, einen Elektrodenhalter in einer Öffnung der Bodenplatte, der die Elektrode hält, eine Halterung für den Trägerkörper, eine Wärmekappe zwischen der Halterung für den Trägerkörper und dem Elektrodenhalter, die eine Öffnung aufweist, um den unteren Endabschnitt der Halterung für den Trägerkörper aufzunehmen und zu halten, ein Schutzelement für die Wärmekappe in Form einer ringähnlichen Platte, die eine obere Oberfläche der Wärmekappe abdeckt und die eine Öffnung aufweist, durch die die Halterung für den Trägerkörper geführt ist.

Allerdings zeigen die bislang bekannten Vorrichtungen keinen ausreichenden Schutz der Dichtung der Elektrodenhalterungen. Dies hat zur Folge, dass die Ausfallwahrscheinlichkeit aufgrund korrosiver Effekte sowie Erdschlüssen erhöht ist. Zudem wurde bisher noch kein ausreichender Schutz der Dichtung vor Korrosion und damit Austrag von die Produktqualität beeinflussenden Stoffen (insbes. Dotierstoffe) gefunden.

Aufgabe der Erfindung ist das Bereitstellen einer Vorrichtung, die diese Effekte deutlich reduziert.

Die Aufgabe der Erfindung wird gelöst durch eine Vorrichtung zum Schutz von Elektrodenhalterungen in CVD Reaktoren, umfassend eine zur Aufnahme eines Filamentstabs geeignete Elektrode auf einer Elektrodenhalterung aus einem elektrisch leitfähigen Material, die in einer Aussparung einer Bodenplatte angebracht ist, wobei ein Zwischenraum zwischen Elektrodenhalterung und Bodenplatte mit einem Dichtungsmaterial abgedichtet ist und das Dichtungsmaterial durch einen ein- oder mehrteilig aufgebauten, ringförmig um die Elektrodenhalterung angeordneten Schutzkörper geschützt wird, der mit zunehmendem radialen Abstand von der Elektrodenhalterung in seiner axialen Ausdehnung abnimmt.

Ebenfalls gelöst wird die Aufgabe durch ein Verfahren zur Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer der zuvor genannten Vorrichtungen befindet, der mittels der Elektrode mit Strom versorgt und der damit durch direkten Stromdurchgang auf eine Temperatur aufgeheizt wird, bei der sich Silicum am Filamentstab abscheidet.

Vorzugsweise ist der Schutzkörper der erfindungsgemäßen Vorrichtung so ausgestaltet, dass bei Betrieb des CVD-Reaktors Reaktionsgase zum unteren Teil des auf der Elektrode befindlichen Filaments, im Folgenden als Stabfuß bezeichnet, geleitet werden. Dies lässt sich z.B. derart bewerkstelligen, dass der Schutzkörper ein oder mehrere konzentrisch um die Elektroden angeordnete Schutzringe umfasst, die einzeln oder in Summe in Richtung der Elektroden in ihrer Höhe zunehmen, so dass von einer Gaseintrittsöffnung bzw. Düse des Reaktors einströmendes Reaktionsgas durch die Geometrie der Schutzringe zum Stabfuß geleitet wird.

Die optimale Geometrie des Schutzkörpers hängt also von der Höhe der Elektrodenhalterung und der Länge der Elektrode ab. Bevorzugt Abmessungen der Elektrodenschutzkörper sind: Durchmesser: 50 - 250 mm besonders bevorzugt 100 - 170 mm, Höhe: 20 - 100 mm besonders bevorzugt 20 - 70 mm, Dicke 10 - 100 mm besonders bevorzugt 10 - 50 mm. Die Steigung der einzeln oder in Kombination verwendeten geometrischen Schutzkörper beträgt bevorzugt 30° - 60°, besonders bevorzug 40° - 50°.

Diese Anordnung des Schutzkörpers ermöglicht ein schnelles und gleichmäßiges Aufwachsen von Silicium am Stabfuß. Es hat sich gezeigt, dass das im Stand der Technik oftmals beobachtete ungleichmäßige Aufwachsen des Siliciums, was zu einem Umfallen des Filaments führen kann, dadurch weitgehend verhindert werden kann, also eine Reduktion der Umfallquote erreicht wird.

Es ist bekannt, dass umgefallene Chargen einen großen wirtschaftlichen Schaden bedeuten. So kann es beispielsweise beim Umfallen der Siliciumstäbe zu Beschädigungen der Reaktorwandung kommen. Die umgefallenen Siliciumstäbe werden dabei durch den Kontakt mit dem Reaktor verunreinigt und müssen an der Oberfläche gereinigt werden. Zusätzlich können umgefallene Chargen nur mit erhöhtem Aufwand aus dem Reaktor ausgebaut werden. Dabei wird die Oberfläche des Siliciums weiter kontaminiert.

Die Erfindung sieht also vor, optimierte Schutzkörper für Dichtungen und Isolierungen an Elektrodenhalterungen einzusetzen.

Die Schutzkörper wurden hinsichtlich ihrer Geometrie und des eingesetzten Materials sowie ihrer Anordnung auf der Bodenplatte optimiert.

Neben der reinen Schutzfunktion für die eingesetzte Dichtung gegen direkte Bestrahlung, wird auch die Strömung des Gases im Reaktionsraum im Bezug auf die Dichtung und Stabfüße thermisch positiv beeinflusst, zumal die Dichtungen einer geringeren Temperatur ausgesetzt sind.

Damit sind ein Anschmoren der Dichtungs- und Isolierungskörper auch bei höheren Dichtungsabmessungen und Versagen durch Erdschluss und Undichtigkeiten des Reaktors zur Umgebung sowie der Eintrag von Dotierstoffen in das System unwahrscheinlicher.

Des Weiteren konnte beobachtet werden, dass eine Oberflächenbehandlung der Schutzringe die Häufigkeit von Erdschlüssen deutlich reduziert.

Wesentlich für das Gelingen der Erfindung war es, geometrische Körper in konzentrischer Anordnung um die Elektrodendurchführung und die Strom führenden Elektroden vorzusehen.

Durch eine solche Anordnung wird nicht nur ein thermischer Schutz des Dichtungs- und Isolierungskörpers der Elektrodenhalterung gegen die Bodenplatte, sondern auch eine Strömungsmodifikation am Stabfuß der abgeschiedenen Polysilicium-Stäbe erreicht.

Korrosive Effekte, die mit einem nicht optimierten Schutzkörper am Dichtungs- und Isolierungsring im Stand der Technik beobachtet wurden, treten bei Verwendung des optimierten Schutzkörpers nicht mehr auf.

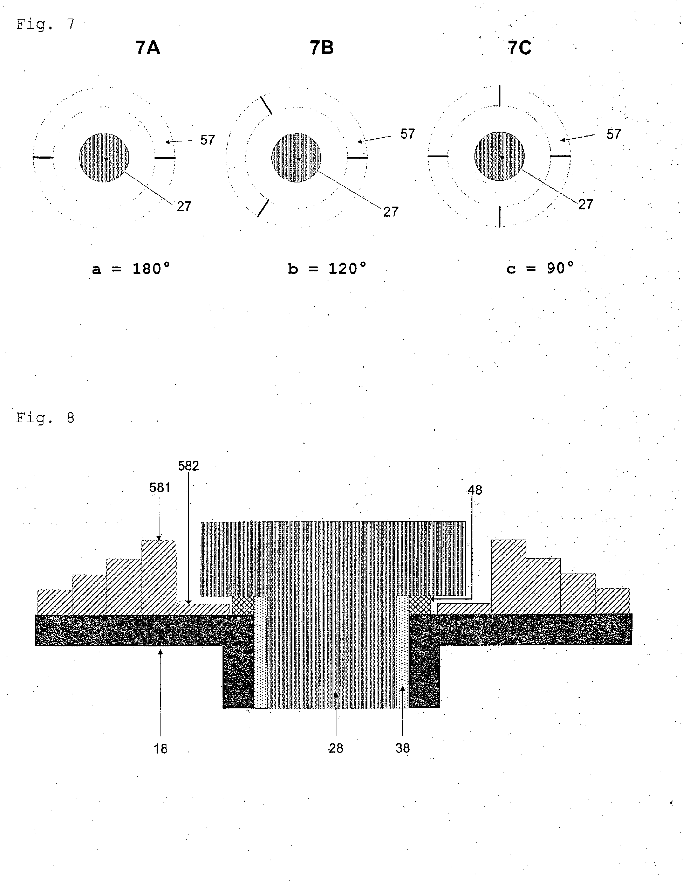

Eine Ausführungsform der Erfindung sieht vor, um die Elektrodenhalterung mehrere Ringe konzentrisch anzuordnen, wobei die Höhe der Ringe mit zunehmendem Radius der Ringe abnimmt, wobei ein zusätzlicher Schutzring mit einem kleineren Radius als die übrigen Schutzringe in einer Aussparung zwischen Elektrode und Bodenplatte vorgesehen wird. Dieser zusätzliche Schutzring umfasst vorzugsweise zwei Halbringe, vgl. **Fig. 7A****.**

Es ist also bevorzugt, in der Nähe der Elektrode einen Ring mit der größten Höhe vorzusehen, wobei mit zunehmendem Abstand von der Elektrode die Höhe der weiteren Ringe abnimmt.

Diese Ausführungsform der Erfindung sieht mehrere Ringe, also mehrere einzelne Körper vor.

Es ist jedoch auch bevorzugt im Rahmen der zweiten Ausführungsform der Erfindung einen einzelnen geometrischen Körper vorzusehen, wobei auch bei diesem Körper die Höhe mit zunehmendem Abstand von der Elektrodenhalterung abnimmt.

Auch bevorzugt ist der Einsatz von geometrischen Körpern jeglicher Form, solange ein Ende der Körpers höher ist als das andere Ende des Körpers.

Die eingesetzten Ringe bzw. Körper können auf der Bodenplatte des Reaktors aufliegen.

Ebenso ist es bevorzugt, die Ringe bzw. Körper in der Bodenplatte teilweise zu versenken.

Die Ringe bzw. Körper beinhalten vorzugsweise transluzenten Quarz (durchlässig für Wellenlängen zwischen 300 - 10000 nm mit einer spektralen Transmission von bis zu 1%), Silber, Silicium (polykristallin und/oder monokristallin), Wolframcarbid, Si-Carbid, mit Silicium beschichteter Graphit, Carbon Fiber reinforced Carbon (CFC) Verbundwerkstoffe, Wolfram oder andere hochschmelzende Metalle.

Aufgrund der hohen thermischen Belastung ist das Überwachsen der Schutzkörper mit einer dünnen Siliciumschicht während des CVD Prozesses besonderst bevorzugt. Die Oberfläche der geometrischen Körper kann insgesamt oder in einzelnen Kompartimenten unbehandelt oder vorbehandelt sein. Es hat sich als vorteilhaft erwiesen, zumindest die Flächen des Schutzrings mit dem kleinsten Durchmesser, der sich in der Nähe der Elektroden befindet, so vor zu behandeln, so dass bei einer Rauhigkeitsmessung (Ra arithmetischer Mittelwert; Kenngröße nach DIN EN ISO 4287) Ra = 10 - 40 erreicht wird.

Bevorzugt ist der Einsatz von Schutzkörpern mit einer Rautiefe von 15 - 30, besonders bevorzugt ist ein Ra zwischen 16 - 25.

Bei Verwendung von Schutzkörpern kann es sich auch um Gussteile aus Silber handeln.

Die Formkörper können einmalige oder mehrmalige Verwendung bei der Abscheidung von polykristallinem Silicium nach dem Siemens-Verfahren finden. Dabei können die Formkörper in abgebürstetem oder nass bzw. trocken gereinigtem Zustand eingesetzt werden.

Beide Ausführungsformen der Erfindung zeichnen sich dadurch aus, dass sie eine gute Abschirmung von Elektrode und Dichtung bewerkstelligen sowie eine lokale Optimierung der Gasströmung bewirken.

Grundsätzlich sind die eingesetzten Formkörper leicht handhabbar.

Der Reaktor umfasst mehrere U-förmige Filamente, an denen sich polykristallines Silicium abscheiden lässt.

Dazu wird mittels Düsen Reaktionsgas umfassend eine Silicium enthaltende Verbindung in den Reaktor eingeführt. Die Filamente werden mittels eines Spannungsanschlusses mit Strom versorgt und auf eine Abscheidetemperatur aufgeheizt.

Der Reaktor umfasst einen Reaktorboden. Auf diesem Reaktorboden sind eine Vielzahl von Elektroden zur Aufnahme der Filamente angebracht.

Die erfindungsgemäße Vorrichtung kommt vorzugsweise bei der Abscheidung von Polysilicium in einem CVD-Reaktor zum Einsatz.

Die Elektrodenhalterung besteht aus elektrisch leitfähigen Metallen, bevorzugt aus einem oder mehreren Materialien ausgewählt aus der Gruppe bestehend aus Messing, Silber und Kupfer oder deren Kombination.

Im Folgenden wird die Erfindung anhand von Figuren erläutert.

### Kurzbeschreibung der Figuren

**Fig. 1** zeigt schematisch die zur Stromversorgung erforderliche Durchführung durch die Bodenplatte eines CVD Reaktors und die zugehörigen Elektroden.
**Fig. 2** zeigt schmematisch zwei Ausführungen **2A** und **2B** von Elektrodenanordnung mit Schutzkörper.
**Fig. 3** zeigt eine Elektrodenanordnung mit mehrteiligen konzentrisch angeordneten Schutzkörpern.
**Fig. 4** zeigt eine Vorrichtung mit einem einteiligen Schutzkörper.
**Fig. 5** zeigt eine Elektrodenanordnung mit nur einem Schutzring.
**Fig. 6** zeigt eine Anordnung wie **Fig. 4** mit Draufsicht.
**Fig. 7** zeigt Ausführungsformen **7A, 7B** und **7C** für geteilte Schutzringe.
**Fig. 8** zeigt eine Ausführungsform für die Kombination aus mehreren in der Höhe ansteigenden Ringen und unter die Elektroden geschobenen Halbringen.

### Liste der verwendeten Bezugszeichen

- **1**: Bodenplatte
- **2**: Elektrodenhalterung
- **3**: Hülse
- **4**: Dichtung
- **5**: Schutzkörper

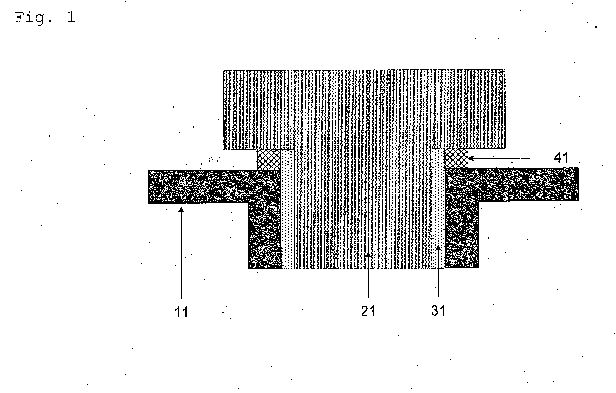

**Fig. 1** zeigt die metallische Bodenplatte **11** eines Reaktors und eine Elektrodenhalterung **21.**

Die Bodenplatte **11** ist mit einer Durchbohrung versehen, die mit einer Hülse **31** ausgekleidet ist und durch die eine Elektrodenhalterung **21** gasdicht, hindurchgeführt und eingepasst ist.

Der Zwischenraum zwischen der Elektrodenhalterung **21** und der Bodenplatte **11** ist mit Dichtung **41,** bevorzugt aus Polytetrafluorethylen (PTFE), abgedichtet. Auch Hülse **31** besteht vorzugsweise aus PTFE.

Als Material für Dichtung **41** haben sich PTFE-Dichtungen, Glimmer-Dichtungen mit PTFE-Auflage und PTFE-Dichtungen mit einem Anteil von 30-40% Siliciumdioxid als geeignet erwiesen. Als besonders geeignet haben sich Dichtungen aus einem restrukturierten PTFE-Dichtungswerkstoff erwiesen.

Elektrodenhalterung **21** umfasst vorzugsweise eines oder mehrere Materialien ausgewählt aus der Gruppe bestehend aus Messing, Silber und Kupfer.

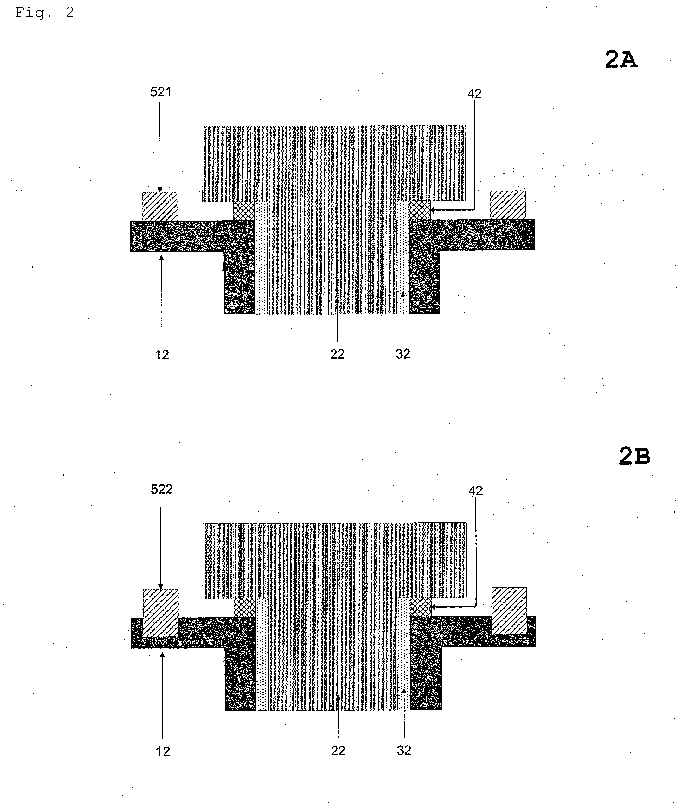

**Fig. 2** zeigt zwei Ausführungsformen für das Anbringen von Schutzringen.

**52** zeigt einen um Elektrodenhalterung **22** angeordneten Schutzring aus Quarz.

**2A** zeigt einen Schutzring **521**, der auf Bodenplatte **12** aufliegt.

**2B** zeigt einen Schutzring **522**, der teilweise in der Bodenplatte **12** versenkt ist.

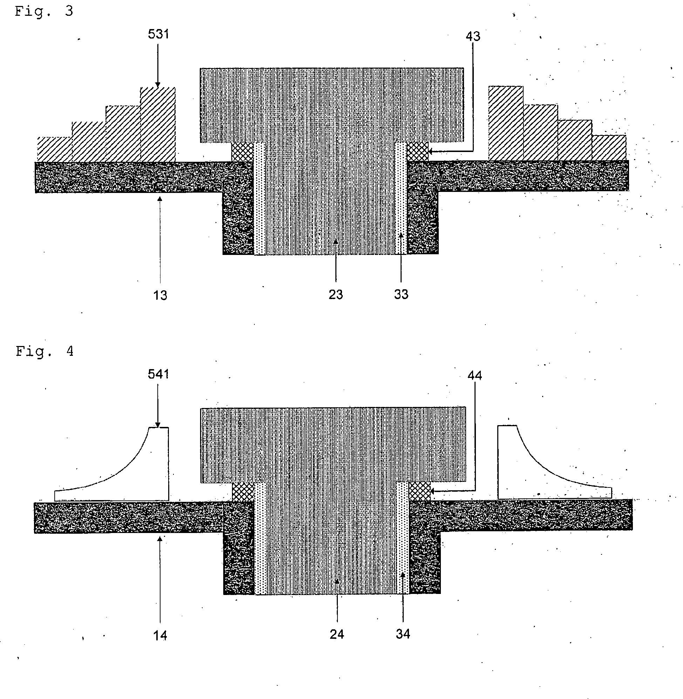

**Fig. 3** zeigt mehrere Schutzringe **531**, die bevorzugt konzentrisch um die Elektrodenhalterung **23** angeordnet sind. Die Schutzringe **531** liegen auf Bodenplatte **13** auf.

**Fig. 4** zeigt eine Ausführungsform für einteilige Schutzringe.

Einen Schutzring **541,** der neben der Elektrodenhalterung **24** angeordnet ist und mit zunehmendem Abstand von der Elektrodenhalterung **24** in seiner Höhe abnimmt. Die maximale Höhe des Schutzrings **541** entspricht etwa dem oberen Ende der Elektrodenhalterung **24** oder geht leicht darüber hinaus. Der Schutzring **541** liegt auf Bodenplatte **14** auf. **44** zeigt die zu schützende Dichtung.

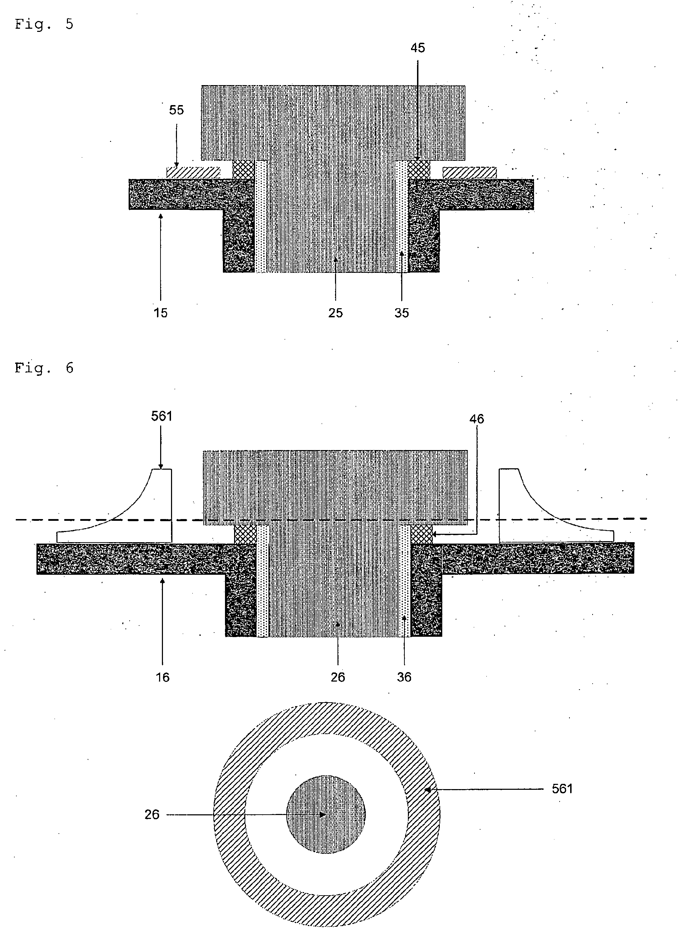

**Fig. 5** zeigt einen zwischen Bodenplatte **15** und Elektroden **25** geschobenen Schutzring **55.** Schutzring **55** ist einteilig aufgebaut und liegt auf Bodenplatte **15** auf.

**Fig. 6** zeigt neben einer Elektrodenanordnung, die **Fig. 4** entspricht eine Draufsicht der Anordnung. Hier wird deutlich, dass es sich um eine ringförmige Anordnung handelt.

**16** zeigt die Bodenplatte, auf der der Schutzring **561** aufliegt.

**Fig. 7** zeigt ebenfalls Draufsichten von drei Ausführungen von Elektrodenanordnungen.

**27** zeigt Elektrodenhalterung, **57** stellt jeweils den Schutzring. dar.

Schutzring **57** ist jeweils geteilt.

**7A** zeigt Schutzring **57**, der zweimal geteilt ist (Winkel 180°).

**7B** zeigt Schutzring **57**, der dreimal geteilt ist (Winkel 120°).

**7C** zeigt Schutzring **57**, der viermal geteilt ist (Winkel 90°).

**Fig. 8** zeigt eine Ausführungsform für die Kombination aus mehreren in der Höhe ansteigenden Ringen **581** und unter die Elektrodenhalterung **28** geschobenen Halbringen.

## Patentansprüche

1. Vorrichtung zum Schutz von Elektrodenhalterungen in CVD Reaktoren, umfassend eine zur Aufnahme eines Filamentstabs geeigneten Elektrode auf einer Elektrodenhalterung aus einem elektrisch leitfähigen Material, die in einer Aussparung einer Bodenplatte angebracht ist, wobei ein Zwischenraum zwischen Elektrodenhalterung und Bodenplatte mit einem Dichtungsmaterial abgedichtet ist und das Dichtungsmaterial durch einen ein- oder mehrteilig aufgebauten, ringförmig um die Elektrodenhalterung angeordneten Schutzkörper geschützt wird, der mit zunehmendem radialen Abstand von der Elektrodenhalterung zumindest abschnittsweise in seiner axialen Ausdehnung abnimmt.

2. Vorrichtung nach Anspruch 1, wobei der Schutzkörper aus mehreren Teilen aufgebaut ist, die konzentrisch um die Elektrodenhalterung angeordnet sind.

3. Vorrichtung nach Anspruch 1 oder nach Anspruch 2, wobei das Material des Schutzkörpers ausgewählt wird aus der Gruppe bestehend aus transluzentem Quarz, Silber, mono- oder polykristallinem Silicium, Wolframcarbid, Siliciumcarbid, mit Silicium beschichtetem Graphit, CFC-Verbundwerkstoffen, Wolfram und anderen hochschmelzenden Metallen.

4. Vorrichtung nach einem der Ansprüche 1 bis 3, wobei der Schutzkörper wenigstens teilweise aus transluzentem Quarz oder aus Silber besteht.

5. Vorrichtung nach einem der Ansprüche 1 bis 4, wobei der Schutzkörper aus mehreren Teilen aufgebaut, von denen wenigstens einer aus transluzentem Quarz oder aus Silber besteht.

6. Vorrichtung nach einem der Ansprüche 1 bis 5, wobei das Dichtungsmaterial zusätzlich durch einen im Zwischenraum zwischen Elektrodenhalterung und Bodenplatte ringförmig um die Elektrodenhalterung angeordneten Schutzkörper geschützt wird.

7. Verfahren zur Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer Vorrichtung nach einem der Ansprüche 1 bis 6 befindet, der mittels der Elektrode mit Strom versorgt und der damit durch direkten Stromdurchgang auf eine Temperatur aufgeheizt wird, bei der sich Silicium am Filamentstab abscheidet.

## Claims

1. Device for protecting electrode holders in CVD reactors, which comprises an electrode suitable for accommodating a filament rod on an electrode holder which is composed of an electrically conductive material and is installed in a recess of a bottom plate, wherein an intermediate space between electrode holder and bottom plate is sealed by means of a sealing material and the sealing material is protected by a protective body which is made up of one or more parts and is arranged in a ring-like manner around the electrode holder and the axial extent of the protective body decreases at least in sections with increasing radial distance from the electrode holder.

2. Device according to Claim 1, wherein the protective body is made up of a plurality of parts which are arranged concentrically around the electrode holder.

3. Device according to Claim 1 or Claim 2, wherein the material of the protective body is selected from the group consisting of translucent silica, silver, monocrystalline or polycrystalline silicon, tungsten carbide, silicon carbide, silicon-coated graphite, CFC composites, tungsten and other high-melting metals.

4. Device according to any of Claims 1 to 3, wherein the protective body consists at least partly of translucent silica or of silver.

5. Device according to any of Claims 1 to 4, wherein the protective body is made up of a plurality of parts of which at least one consists of translucent silica or of silver.

6. Device according to any of Claims 1 to 5, wherein the sealing material is additionally protected by a protective body arranged in a ring-like manner around the electrode holder in the intermediate space between electrode holder and bottom plate.

7. Process for producing polycrystalline silicon, which comprises introducing a reaction gas containing a silicon-containing component and hydrogen into a CVD reactor containing at least one filament rod which is located on a device according to any of Claims 1 to 6, is supplied with electric power by means of the electrode and is thus heated by direct passage of electric current to a temperature at which silicon deposits on the filament rod.

## Revendications

1. Dispositif de protection de supports d'électrodes dans des réacteurs CVD, comprenant une électrode apte à recevoir un barreau de filament sur un support d'électrode en un matériau électriquement conducteur, qui est placé dans une découpe d'une plaque de fond, dans lequel un espace intermédiaire entre le support d'électrode et la plaque de fond est obturé par un matériau d'étanchéité et le matériau d'étanchéité est protégé par un corps de protection composé d'une ou de plusieurs parties, disposé en forme d'anneau autour du support d'électrode, qui diminue au moins localement dans son extension axiale avec l'augmentation de la distance radiale à partir du support d'électrode.

2. Dispositif selon la revendication 1, dans lequel le corps de protection est composé de plusieurs parties, qui sont disposées de façon concentrique autour du support d'électrode.

3. Dispositif selon la revendication 1 ou selon la revendication 2, dans lequel le matériau du corps de protection est choisi dans le groupe composé de quartz translucide, d'argent, de silicium mono- ou polycristallin, de carbure de tungstène, de carbure de silicium, de graphite revêtu de silicium, de matériaux composites CFC, de tungstène et d'autres métaux à haut point de fusion.

4. Dispositif selon l'une quelconque des revendications 1 à 3, dans lequel le corps de protection se compose au moins en partie de quartz translucide ou d'argent.

5. Dispositif selon l'une quelconque des revendications 1 à 4, dans lequel le corps de protection est composé de plusieurs parties, dont au moins une se compose au moins en partie de quartz translucide ou d'argent.

6. Dispositif selon l'une quelconque des revendications 1 à 5, dans lequel le matériau d'étanchéité est en outre protégé par un corps de protection disposé en forme d'anneau autour du support d'électrode dans l'espace intermédiaire entre le support d'électrode et la plaque de fond.

7. Procédé de fabrication de silicium polycristallin, comprenant l'introduction d'un gaz de réaction contenant un composant contenant du silicium et de l'hydrogène dans un réacteur CVD contenant au moins un barreau de filament, qui se trouve sur un dispositif selon l'une quelconque des revendications 1 à 6, qui est alimenté en courant au moyen de l'électrode et qui est ainsi chauffé par passage direct de courant à une température, à laquelle le silicium se dépose sur le barreau de filament.
